# EUROPEAN PATENT SPECIFICATION

(11) **EP 1 364 458 B1**
(45) Date of publication and mention of the grant of the patent: **14.11.2007**
(21) Application number: 01959834.1
(22) Date of filing: 26.07.2001
(51) Int. Cl.: H03F 1/52, H03F 3/45

(54) **PROTECTION CIRCUIT FOR EXTENDING HEADROOM WITH OFF-CHIP INDUCTORS**
SCHUTZSCHALTUNG ZUR ERWEITERTEN DYNAMIK MIT INDUKTIONEN AUSSERHALB DES HALBLEITERPLÄTTCHENS
CIRCUIT DE PROTECTION SERVANT A L'EXTENSION DE LA MARGE DE SECURITE AVEC DES INDUCTEURS HORS PUCE

(30) Priority: 28.07.2000 US 221617 P; 03.07.2001 US 897601
(43) Date of publication of application: 26.11.2003
(73) Proprietor: Broadcom Corporation, Irvine, CA 92617 (US)
(72) Inventor: BURNS, Lawrence, M., Laguna Hills, CA 92653 (US); DAUPHINEE, Leonard, Irvine, CA 92618 (US)
(74) Representative: Jehle, Volker Armin
(86) International application number: PCT/US2001/041418
(87) International publication number: WO 2002/011281

(56) References cited:
- GB-A- 1 585 079
- US-A- 5 177 378
- US-A- 5 196 805

## Description

### BACKGROUND OF THE INVENTION

### Field of the Invention

The invention generally relates to variable gain amplifiers and applications of the same. In an embodiment, the variable gain amplifier is used in a set-top control box for the delivery of cable television service to a customer. In another embodiment, the variable gain amplifier is used in a cable modem.

### Related Art

In modem sub-micron semiconductor processes, power supply voltages continue to be reduced. In an example used herein, the power supply voltage is 3.3V. This is less than the more common value of 5V used by most bipolar processes. More recent complementary metal-oxide-semiconductor (CMOS) processes operate at 1.2V. Because of this reduced power supply voltage, it is no longer possible to "stack" transistors on top of one another to improve bandwidth and linearity. There is simply not enough voltage dynamic range. In fact, even a simple differential amplifier may not have enough dynamic range to operate properly when the signals at the output have large amplitudes.

The need for very good linearity is even more striking when the input to the chip is single-ended, rather than differential. This requires even more dynamic range at the output of the amplifier. Being able to apply single-ended signals to the chip avoids the cost of an external balun transformer. What is needed is a system and method for improving the dynamic range of an amplifier while providing protection to the on-chip components.

### SUMMARY OF THE INVENTION

This invention uses external surface mount inductors or surface mount ferrite beads to connect the output nodes of multiple differential amplifiers to V_{DD} (the positive power supply). The external inductors or ferrites provide a short-circuit at DC and a high impedance over a range of operating frequencies (e.g., 50-860 MHz). This allows for much greater dynamic range on the internal differential pairs.

A further feature of this invention is a special on-chip biasing arrangement at the output that prevents damage from occurring to the chip, should one of the above-mentioned inductors or ferrites not be installed, or become an open-circuit.

### BRIEF DESCRIPTION OF THE FIGURES

FIG. 1 illustrates an electronic circuit in an embodiment of the present invention:
FIG. 2 illustrates an exemplary Community Antenna Television (CATV) (also referred to as cable TV);
FIGs. 3A-3B illustrate two embodiments of the amplifier of FIG. 2;
FIG. 4A illustrates one embodiment of the present invention wherein the amplifier circuit assembly of FIG. 3A is depicted;
FIG. 4B illustrates one embodiment of the present invention wherein the amplifier array of FIG. 3B is depicted;
FIG. 4C illustrates a typical differential pair amplifier of the amplifier array depicted in FIG. 4B;
FIG. 5 illustrates a mixer used in an embodiment of the present invention;
FIG. 6 illustrates a typical integrated circuit having a differential pair amplifier coupled to on-chip impedances;
FIG. 7 illustrates an integrated circuit having a differential pair amplifier coupled to on-chip impedances and to off-chip inductors;
FIG. 8 illustrates an integrated circuit having a differential pair amplifier coupled to on-chip impedances and to off-chip ferrite beads;
FIG. 9A illustrates a circuit wherein one ferrite bead has failed;
FIG. 9B illustrates a circuit wherein both ferrite beads have failed;
FIG. 10 illustrates an embodiment of the present invention having a protection circuit disposed;
FIG. 11A illustrates an embodiment of the present invention having a protection circuit disposed thereon, wherein one ferrite bead has failed; and
FIG. 11B illustrates an embodiment of the present invention having a protection circuit disposed thereon, wherein both ferrite beads have failed.

### DETAILED DESCRIPTION OF THE PREFERRED EMBODIMENTS

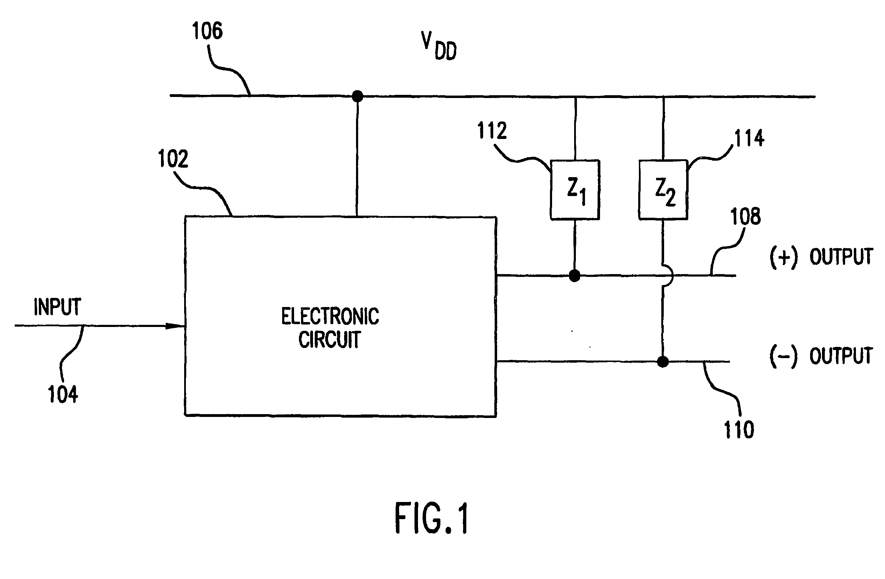

Looking first at FIG. 1, an exemplary circuit depicting an embodiment of the invention is illustrated. An electronic circuit 102 is seen receiving an input 104. Input 104 can be a single input or a differential input. Electronic circuit 102 is further connected to a bias voltage 106. Bias voltage 106 is shown as V_{DD} and is the common direct current (DC) voltage for the overall circuit for which electronic circuit 102 is a part. Electronic circuit 102 is shown having a differential output comprising a positive output 108 and a negative output 110. One skilled in the art(s) will appreciate, based on the teachings contained herein, that the invention will also apply to an electronic circuit having a single output. Positive output 108 is connected to bias voltage 106 through a first impedance 112, and negative output 110 is connected to bias voltage 106 through a second impedance 114. First impedance 112 and second impedance 114 have substantially zero DC voltage drop and are substantially an open circuit to signals in the frequency range of interest.

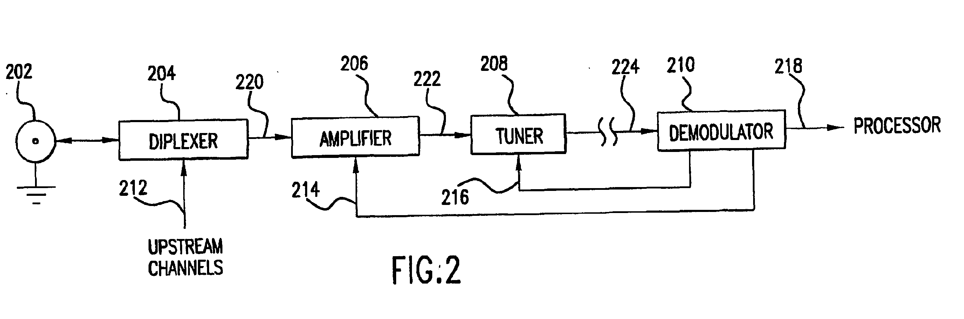

Looking now to FIG. 2, an example of a community antenna television (CATV) system (also referred to as cable television) is shown. A CATV cable 202 is shown connected to a diplexer 204. Diplexer 204 includes filters (not shown) that permit upstream channels 212 to be passed to cable 202 and allow downstream channels 220 to be passed to an amplifier 206. Preferably, for the U.S. and Canada, the up-stream channels cover from 5-42 MHz and the downstream channels cover from 54-860 MHz. Concentrating on the down-stream, the output of amplifier 206 is an amplified signal 222 that is routed to a tuner 208. Tuner 208 includes at least one bandpass filter that selects a single down-stream channel 224 having a 6 MHz bandwidth. In embodiments, down-stream channel 224 is centered at 44 MHz. Down-stream channel 224 is then routed to a demodulator 210, which outputs a demodulated signal 218 for further processing before being sent to a user device (e.g. television set or computer). As an example, and not meant to be limiting, demodulated signal 218 can be digital video or cable modem data. Demodulator 210 also analyzes the power of down-stream channel 224 and outputs a feedback 216 to control an amplifier (not shown) in tuner 208 and outputs a feedback 214 to control amplifier 206.

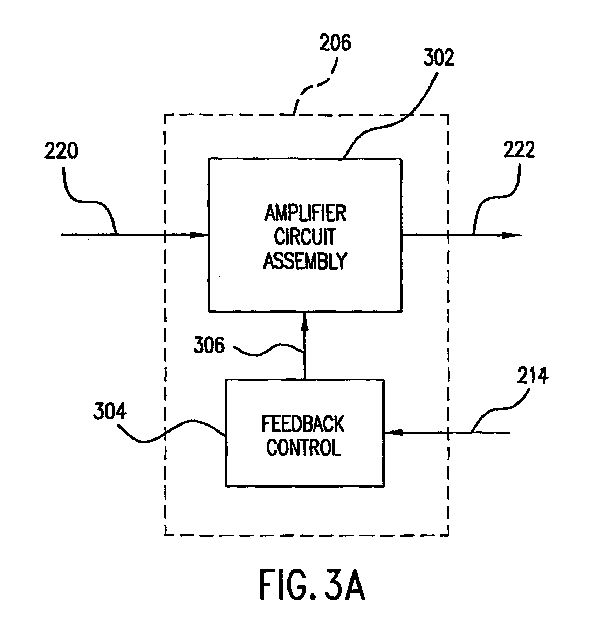

In FIG. 3A, an embodiment of amplifier 206 is illustrated. Amplifier 206 is comprised of an amplifier circuit assembly 302 that receives downstream channels 220. Amplifier circuit assembly 302 also receives a control signal 306 from a feedback control 304. Feedback control 304 is controlled by feedback 214. Further details of the purpose and operation of feedback control 304 and control signal 306 are presented in U.S. patent application "Extended Range Variable Gain Amplifier," Application No. 09/897,601, filed July 3, 2001. Amplifier circuit assembly 302 outputs amplified signal 222.

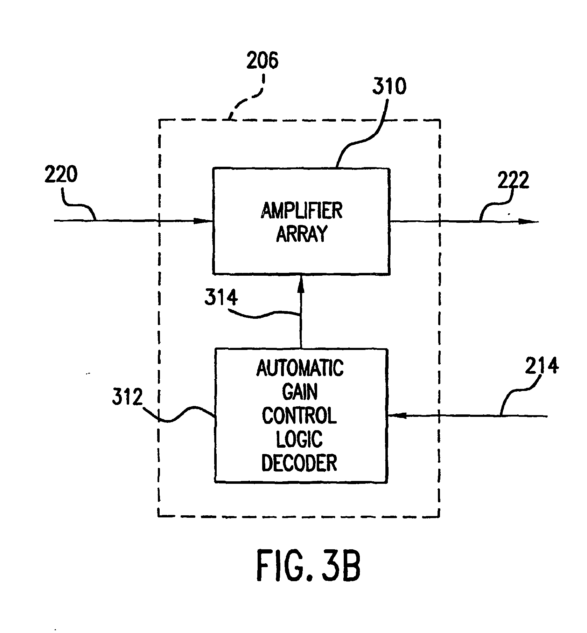

A second embodiment is illustrated in FIG. 3B. Amplifier 206 is shown comprising an amplifier array 310 and an automatic gain control (AGC) logic decoder 312. Amplifier array receives downstream channels 220 and outputs amplified signal 222. Amplifier array 310 also receives AGC control signal 314 from AGC logic decoder 312 under the control of feedback 214. Further details of the purpose and operation of AGC logic decoder 312 and AGC control signal 314 are presented in U.S. patent application "Extended Range Variable Gain Amplifier," Application No. 09/897,601, filed July 3, 2001.

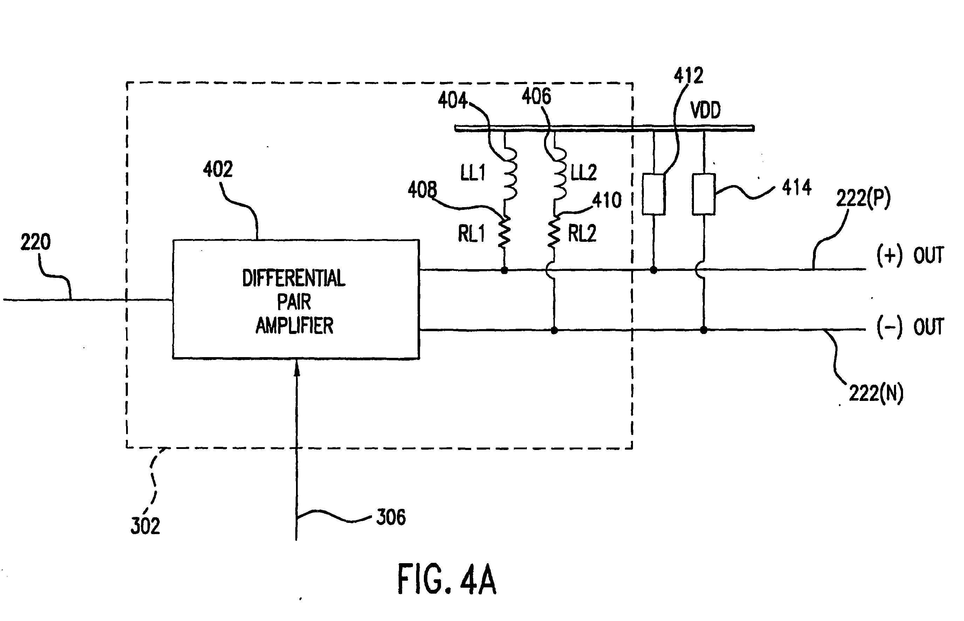

Amplifier circuit assembly 302 is illustrated in FIG. 4A as comprising a differential pair amplifier 402 having a positive amplified signal 222(P) and a negative amplified signal 222(N). Within amplifier circuit assembly 302, positive amplified signal 222(P) is seen being connected to V_{DD} through a first load inductor 404 and a first load resistor 408 (illustrated as LL1 and RL1, respectively), and negative amplified signal 222(N) is seen being connected to V_{DD} through a second load inductor 406 and a second load resistor 410 (illustrated as LL2 and RL2, respectively). External to amplifier circuit assembly 302, positive amplified signal 222(P) is shunted through a first impedance 412 to V_{DD} and negative amplified signal 222(N) is shunted through a second impedance 414 to V_{DD}. First impedance 412 and second impedance 414 are selected such that they provide substantially zero impedance to DC voltage and provide a substantially high impedance to signals in the frequency range of interest. In an embodiment, amplifier circuit assembly 302 is disposed on a common integrated circuit (IC) substrate and first impedance 412 and second impedance 414 are mounted external to the common substrate.

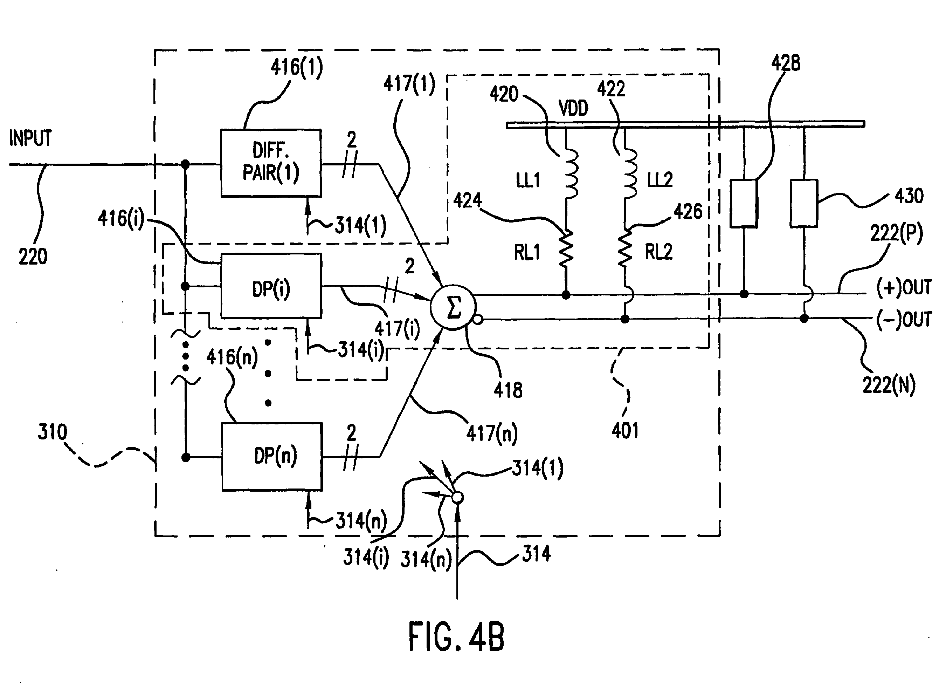

Amplifier array 310 is further illustrated in FIG. 4B. Downstream channels 220 are accepted by amplifier array 310 and routed to each of a plurality of differential pair amplifiers 416(1) through 416(n). In an implementation, some inputs can be attenuated through a resistor ladder (typically on-chip). The output of any differential pair amplifier 416(i) is a differential pair output signal 417(i). Differential pair output signal 417(1) through 417(n) are routed to a combiner 418. In one embodiment, combiner 418 is a summer. Combiner 418 combines differential pair output signals 417(i) and outputs positive amplified signal 222(P) and negative amplified signal 222(N). Positive amplified signal 222(P) is seen being connected to V_{DD} through a first load inductor 420 and a first load resistor 424 (illustrated as LL1 and RL1, respectively), and negative amplified signal 222(N) is seen being connected to V_{DD} through a second load inductor 422 and a second load resistor 426 (illustrated as LL2 and RL2, respectively). External to amplifier array 310, positive amplified signal 222(P) is shunted through a first impedance 428 to V_{DD} and negative amplified signal 222(N) is shunted through a second impedance 430 to V_{DD}. First impedance 428 and second impedance 430 are selected such that they provide substantially zero impedance to DC voltage and provide a substantially high impedance to signals in the frequency range of interest. In an embodiment, amplifier circuit assembly 310 is disposed on a common integrated circuit (IC) substrate and first impedance 428 and second impedance 430 are mounted external to the common substrate.

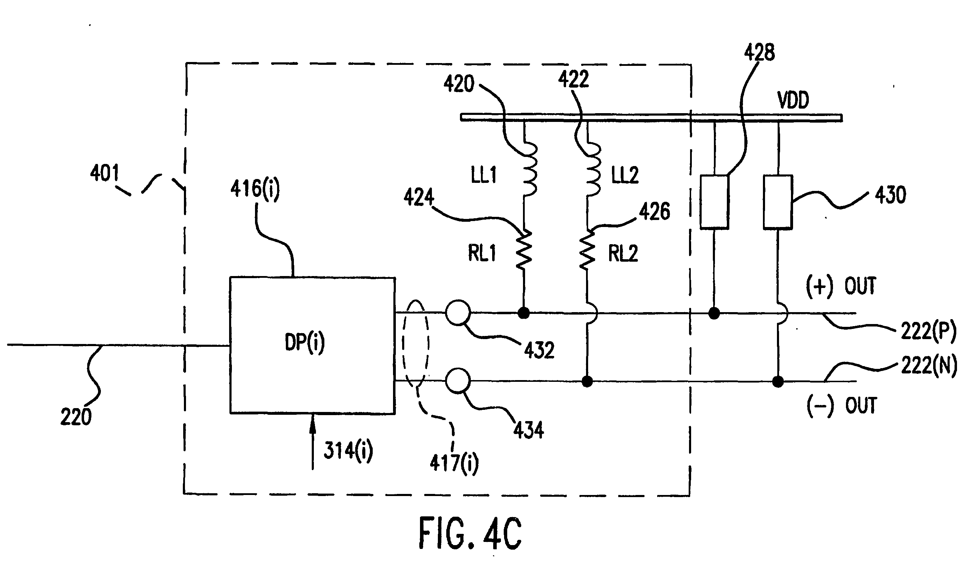

A representative amplifier circuit assembly 401 is illustrated in FIG. 4C. Nodes 432 and 434 illustrate the combining of the plurality of differential pair output signals 417(i), wherein node 432 is the positive node outputting positive amplified signal 222(P) and node 434 is the negative node outputting negative amplified signal 222(N).

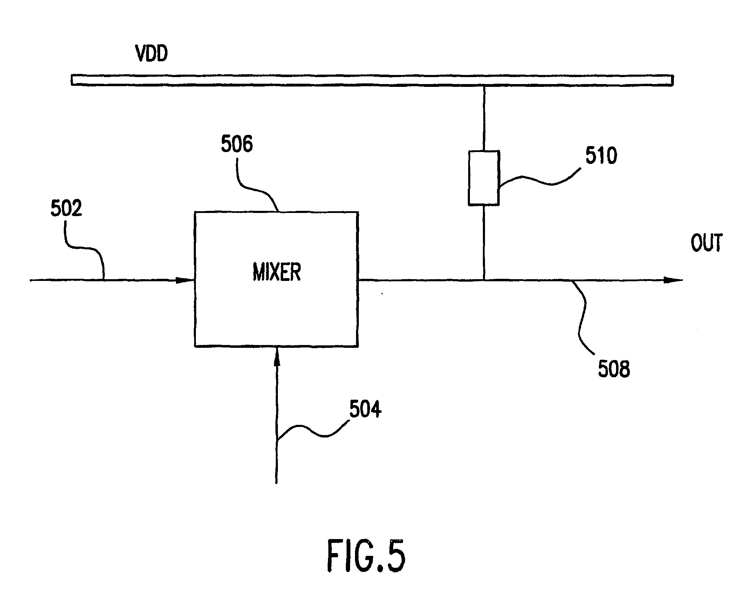

FIG. 5 illustrates an alternate embodiment of the invention. In FIG. 5, a mixer 506 is illustrated receiving an input signal 502 and a mixing signal 504. Mixer 506 outputs a mixed output signal 508. Mixed output signal 508 is connected through an impedance 510 to V_{DD}. Impedance 510 is selected such that it provides substantially zero impedance to DC voltage and provides a substantially high impedance to signals in the frequency range of interest. Mixed output signal 508 is shown as being a single output. Those skilled in the relevant art(s) will appreciate, based on the teachings contained herein, that the invention with respect to the mixer embodiment also applies to the implementation wherein mixed output signal 508 is a differential output.

The circuits shown in FIGs. 4A-4C illustrate downstream channels 220 as being a single input signal. The invention also applies to the implementation wherein downstream channels 220 is a differential input, as will be understood by those skilled in the art(s), based on the teachings contained herein.

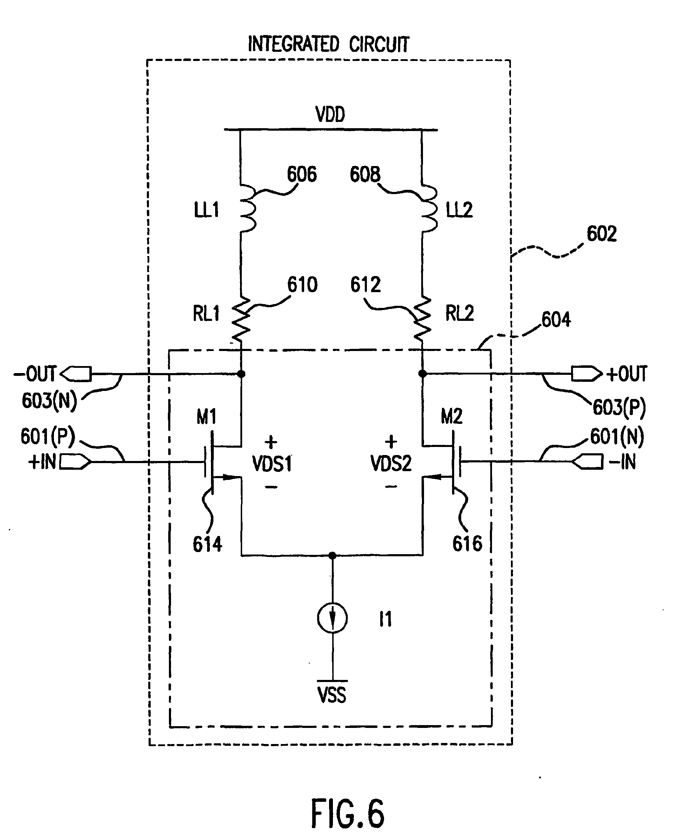

FIG. 6 illustrates an example of amplifier circuit assembly 302 and representative amplifier circuit assembly 401. FIG. 6 depicts a typical integrated circuit 602 as comprising a differential pair 604, a first load inductor 606, a first load resistor 610, a second load inductor 608, and a second load resistor 612. Differential pair 604 further comprises a pair of transistors 614 and 616. Transistors 614 and 616 have a common source tied to V_{SS}. Transistor 614 is shown accepting a positive input signal 601(P) and transistor 616 is shown accepting a negative input signal 601(N). Transistor 614 is shown having a negative output 603(N) and transistor 616 is shown having a positive output 603(P). Negative output 603(N) is connected through first load inductor 606 and first load resistor 610 to V_{DD} and positive output 603(P) is connected through second load inductor 608 and second load resistor 612 to V_{DD}.

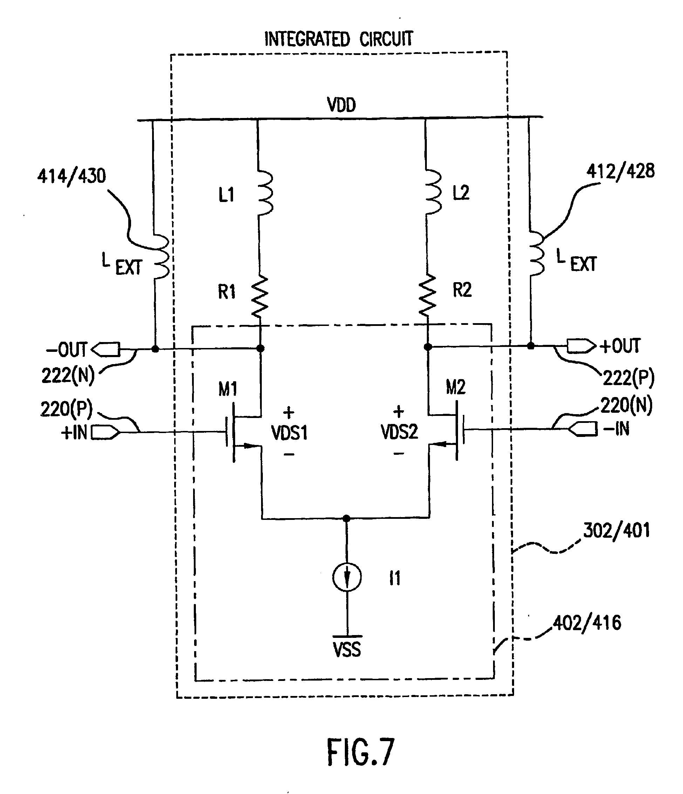

FIG. 7 expands on FIG. 4A and FIG. 4C and illustrates an integrated circuit connected with external impedances. Amplifier circuit assembly 302;401 is comprised of on-chip resistors and inductors (shown as R1, R2, L1, and L2 in FIG. 7), and differential pair amplifier 402;416 receiving differential downstream channels 220(P) and 220(N). Differential pair amplifier 402;416 is further comprised of transistors receiving differential downstream channels 220(P) and 220(N) at their respective gates, further configured with a common source connected to V_{SS}, and having the output signals 222(N) and 222(P) found at the drain. Output signal 222(P) is connected through first impedance 412;428 to VDD, and output signal 222(N) is connected through second impedance 414;430 to VDD. In this circuit, first impedance 412;428 and second impedance 414;430 are shown as inductors, although other impedances (such as those that provide a substantially short circuit to DC voltage while being a high impedance to signals in the frequency range of interest) may be used, as will be apparent to those skilled in the art(s). Further, the components of amplifier circuit assembly 302;401 are preferably mounted on a common IC substrate, whereas first impedance 412;428 and second impedance 414;430 are preferably mounted external to the common substrate.

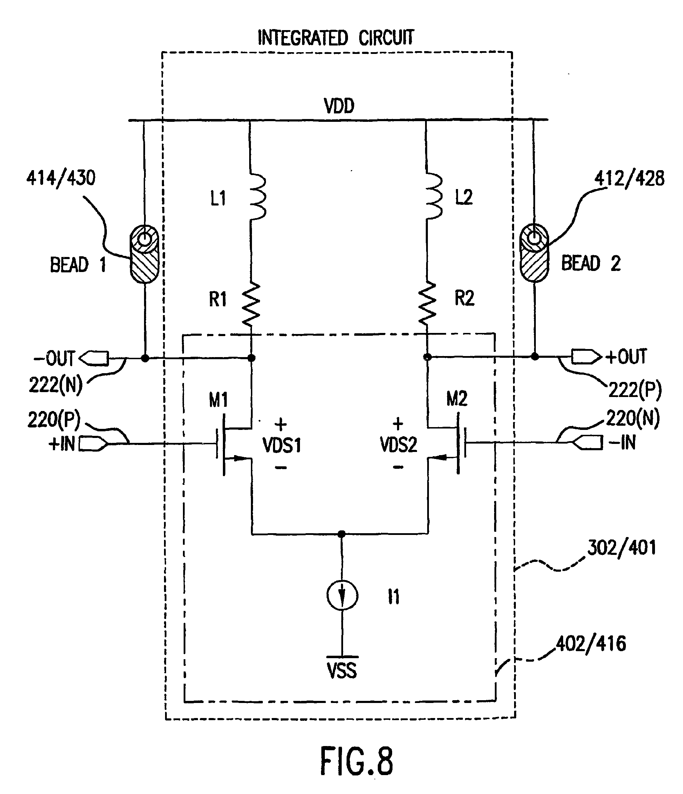

FIG. 8 expands on FIG. 4A and FIG. 4C and illustrates an integrated circuit connected to ferrites beads. Amplifier circuit assembly 302;401 is comprised of on-chip resistors and inductors (shown as R1, R2, L1, and L2 in FIG. 7), and differential pair amplifier 402;416 receiving differential downstream channels 220(P) and 220(N). Differential pair amplifier 402;416 is further comprised of transistors receiving differential downstream channels 220(P) and 220(N) at their respective gates, further configured with a common source connected to V_{SS}, and having the output signals 222(N) and 222(P) found at the drain. Output signal 222(P) is connected through first impedance 412;428 to VDD, and output signal 222(N) is connected through second impedance 414;430 to VDD. In this circuit, first impedance 412;428 and second impedance 414;430 (which are shown as inductors in FIG. 7) are shown as ferrite beads. Further, the components of amplifier circuit assembly 302;401 are preferably mounted on a common IC substrate, whereas first impedance 412;428 and second impedance 414;430 are preferably mounted external to the common substrate.

In the following discussion, values have been selected to illustrate the present invention. These values of voltage, resistance, inductance, and current are provided for purposes of illustration only. They are not meant to be limiting.

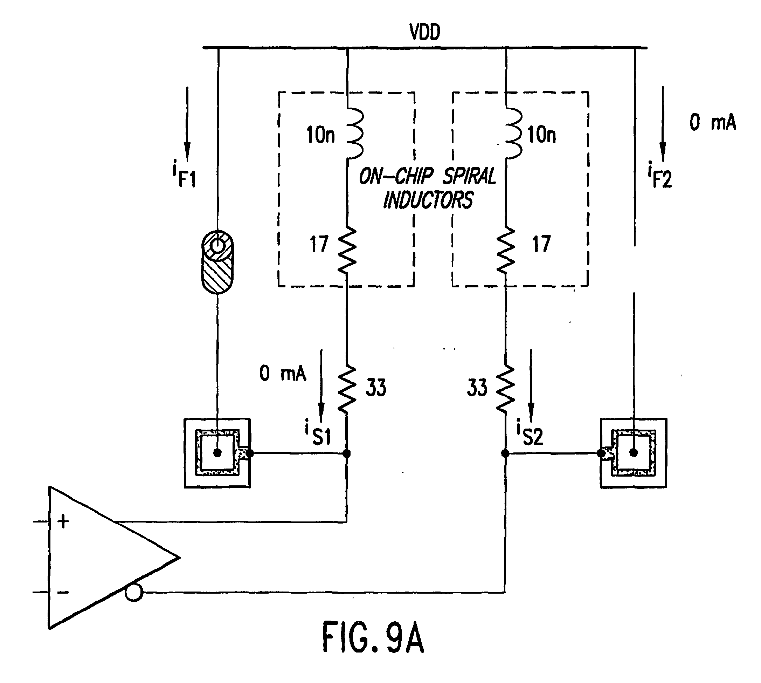

In the circuit of FIG. 8, wherein the outputs of the amplifier circuit assembly are connected through the external ferrite beads to V_{DD}, and for the example where V_{DD} is 3.3 volts, the DC current flowing through the ferrite beads (i_{F1} and i_{F2}) is 49.3 mA, and the DC current flowing through the on-chip spiral inductors (i_{S1} and i_{S2}) is zero amps. In FIG. 9A, a circuit is shown for the example wherein the ferrite beads have a minimum inductance of 1 µH and the on-chip spiral inductors have a value of 10 nH with a total series resistance of 50 Ω. In FIG. 9A, one of the beads has failed and is open circuited, and thus i_{F2} is 0 amps. As a result of the bead failing, i_{F1} will be 59.7 mA, i_{S2} will be 38.4 mA, and i_{S1} remains at 0 mA. The value of i_{S2} of 38.4 mA exceeds the desired design limit of the spiral inductor, and may damage the entire chip.

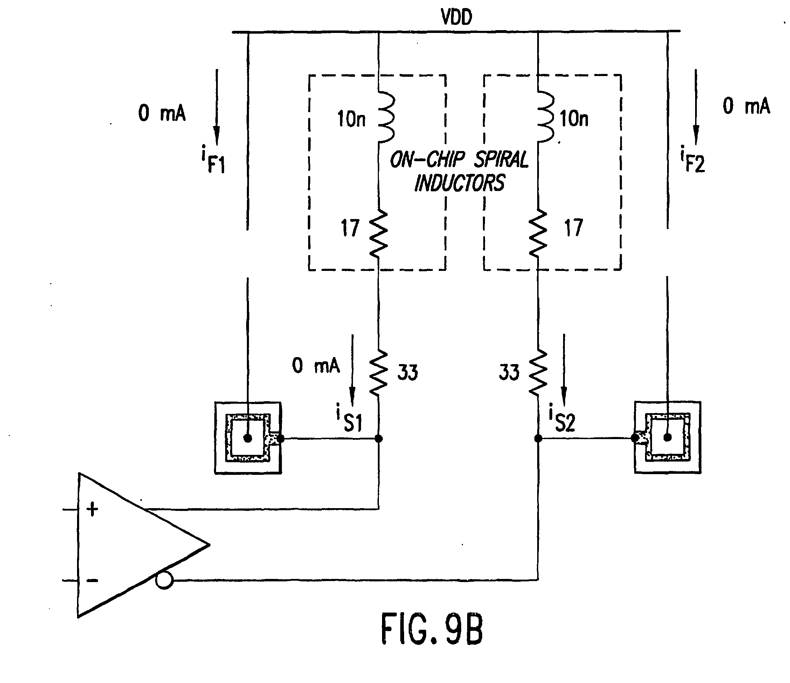

In FIG. 9B, the example wherein both ferrite beads have failed is shown. In this example, both i_{F1} and i_{F2} will be 0 mA, while is, and i_{S2} will be 47.2 mA. Again, this current exceeds the desired design limit of the spiral inductor, and may damage the chip. What is needed is an enhancement to the circuit that will keep i_{S1} and i_{S2} below the desired design limit of the spiral inductor.

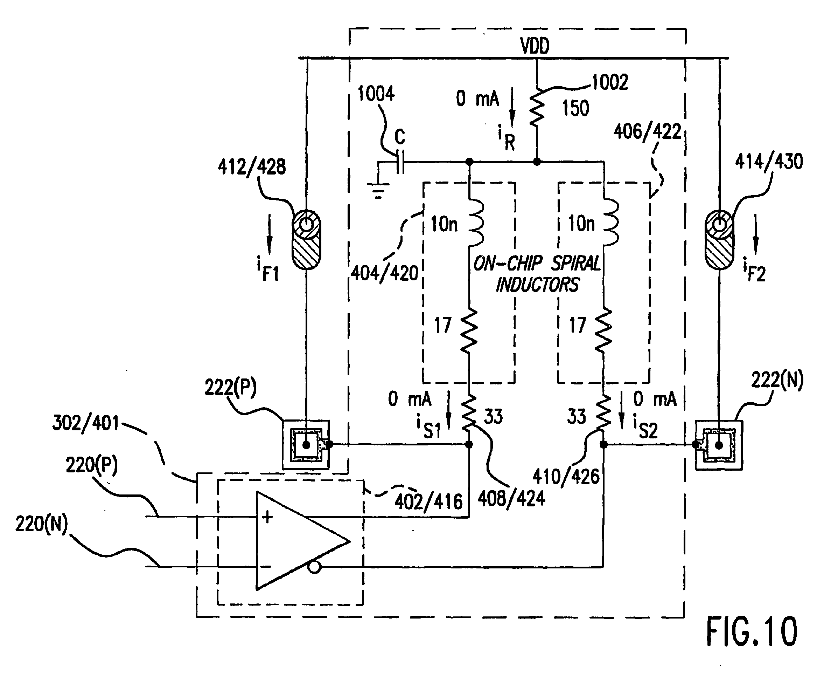

Looking now to FIG. 10, the present invention is illustrated. An on-chip resistor 1002 is connected between a common node of first load inductor 404;420 and second load inductor 406;422 and V_{DD}. An exemplary value for on-chip resistor 1002 is 150 Ω. Also connected to the same node is an on-chip capacitor 1004. On-chip capacitor 1004 is further connected to a potential that is substantially equal to ground at the frequency range of interest. In this example, i_{F1} and i_{F2} will be 49.3 mA, while i_{S1}, i_{S2}, and i_{R} will be 0 mA.

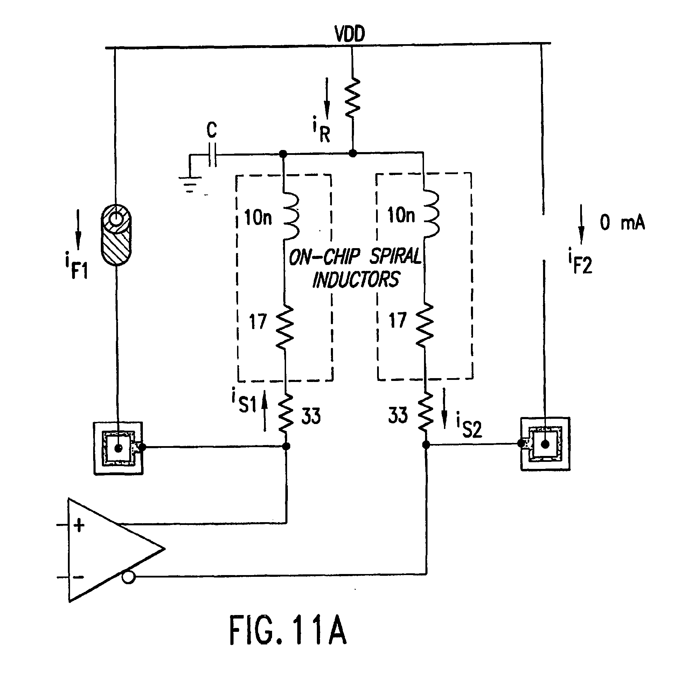

Looking now to FIG. 11A, the condition wherein one ferrite bead fails is shown. In this example, i_{F2} will be 0 mA, while i_{F1} will be 91.3 mA, i_{S2} will be 24.6 mA, i_{S1} will be 18.4 mA (in the direction shown by the arrow), and i_{R} will be 6.1 mA. Thus, the maximum current flowing through either inductor will be 24.6 mA, which is within the desired design limit of the spiral inductor. As a result, if a single ferrite bead fails, the addition of on-chip resistor 1002 and on-chip capacitor 1004 will protect the chip from damage.

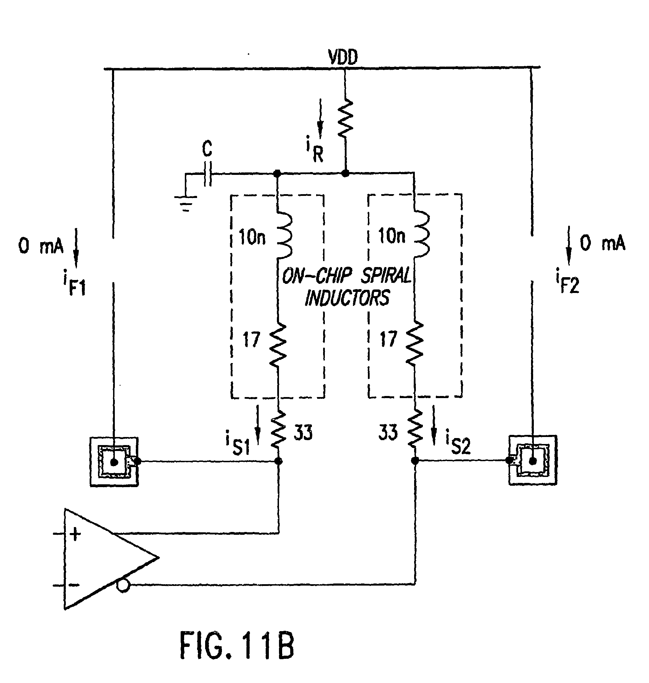

In FIG. 11B, the condition wherein both ferrite beads fail is shown. In this example, i_{F1} and i_{F2} will be zero and i_{S1} and i_{S2} will be 9.2 mA. The current through on-chip resistor 1002 will be 18.4 mA. Thus, the maximum current flowing through either inductor will be 9.2 mA, which is within the desired design limit of the spiral inductor. As a result, if both ferrite beads fail, the addition of on-chip resistor 1002 and on-chip capacitor 1004 will protect the chip from damage.

In each of the examples given above, the values are provided for purpose of illustration and not limitation. One skilled in the relevant art(s) will understand, based on the teachings contained herein, that a change in the value of the bias voltage will result in a change in the values of the currents through the components of the circuits. Further, the value of the on-chip resistor is provided for purpose of illustration and not limitation, and other values of resistance can be used without deviating from the spirit and intent of the invention. These alternate values of resistance would also change the currents through the various components of the circuit.

It should be understood that the invention also covers the embodiment wherein on-chip resistor 1002 and on-chip capacitor 1004 are added to the circuit in an off-chip configuration.

### Conclusion

Benefits of the present invention are, at least, and by way of example and not limitation, the following:
Use of inexpensive external components (surface mount ferrites or inductors) which raise the DC voltage on each gain stage output, while having little or no effect on AC performance.
The inclusion of an internal resistor-capacitor circuit that causes the currents and voltages inside the chip to be reduced, thus avoiding damage to the chip, should one or both of the external ferrites or inductors be missing.
Little change to original internal circuitry of the chip is required, with the exception of a simple resistor-capacitor circuit to prevent damage.
No common mode output voltage control circuits are required. The outputs are always connected to V_{DD}.
Ferrites or inductors allow the output voltage to swing above and below the bias voltage for more dynamic range.
This application can be used with cable modems, TV tuners, and set-top boxes.
This chip is a variable gain, low noise amplifier with a specified input match.

While various embodiments of the present invention have been described above, it should be understood that they have been presented by way of example only, and not limitation. For example, while the invention has been described in terms of differential pair amplifiers, one skilled in the art would recognize that the instant invention could be applied to single output amplifiers. It will be understood by those skilled in the art that various changes in form and details can be made therein without departing from the spirit and scope of the invention as defined in the appended claims. Thus, the breadth and scope of the present invention should not be limited by any of the above-described exemplary embodiments, but should be defined only in accordance with the claims.

## Claims

1. An electronic circuit assembly, comprising:
- at least one differential pair amplifier (402,416) including a positive output coupled to a first load inductor (404,420) and a negative output coupled to a second load inductor (406,422);
- a first shunt (412,428) having a first off-chip impedance, the positive output coupled to a bias voltage (VDD) via the first shunt (412,428);
- a second shunt (414,430) having a second off-chip impedance, the negative output coupled to the bias voltage (VDD) via the second shunt (414,430), wherein the first shunt (412,428) is a first inductor or a first ferrite bead and the second shunt (414,430) is a second inductor or a second ferrite bead and
- a resistor-capacitor circuit including:
- a common point capacitor (1004), and
- a common point resistor (1002) having a first terminal coupled to the bias voltage (VDD) and a second terminal coupled to the first load inductor (404,420) and second load inductor (406,422), and wherein the common point capacitor (1004) is coupled between the second terminal and a ground and the resistor-capacitor circuit is configured to limit a maximum current in the first and second load inductors (404,420; 406,422) when at least one of the first shunt (412,428) and second shunt (414,430) is open circuited.

2. The electronic circuit assembly of claim 1, wherein the impedance of the first shunt (412,428) and the impedance of the second shunt (414,430) are selected to allow the at least one differential pair amplifier (402,416) to generate a positive amplified signal (222(P)) at the positive output that is greater than the bias voltage (VDD) and a negative amplified signal (222(N)) at the negative output that is greater than the bias voltage (VDD).

3. The electronic circuit assembly of claim 1, wherein the at least one differential pair amplifier (402,416) and the resistor-capacitor circuit are integrated on a first substrate and the first shunt (412,428) and the second shunt (414,430) are integrated on a second substrate.

4. The electronic circuit assembly of claim 1, wherein the at least one differential pair amplifier (402,416) is configured to amplify signals having frequencies of 54-860 MHz to generate a positive amplified signal (222(P)) at the positive output and a negative amplified signal (222(N)) at the negative output.

5. The electronic circuit assembly of claim 1, further comprising:
a first load resistor (408,424) coupled between the first load inductor (404,420) and the positive output; and
a second load resistor (410,426) coupled between the second load inductor (406,422) and the negative output.

6. A method of extending dynamic range of an amplifier (206) biased at a bias voltage (VDD), the amplifier (206) including a first load inductor (404,420) coupled between a positive output and the bias voltage (VDD) and a second load inductor (406,422) coupled between a negative output and the bias voltage (VDD), comprising:
- differentially amplifying signals to generate an output signal including a positive amplified signal (222(P)) at the positive output and a negative amplified signal (222(N)) at the negative output;
- coupling the positive amplified signal (222(P)) to the bias voltage (VDD) of the amplifier (206) via a first shunt (412,428) having a first off-chip impedance and the negative amplified signal (222(N)) to the bias voltage (VDD) via a second shunt (414,430) having a second off chip impedance for permitting the output signal to have a voltage swing greater than the bias voltage (VDD); wherein the first shunt (412,428) is a first inductor or a first ferrite bead and the second shunt (414,430) is a second inductor or a second ferrite bead and
- coupling the bias voltage (VDD) to the first load inductor (404,420) and the second load inductor (406,422) via a resistor-capacitor circuit for limiting a maximum current in the first and second load inductors when at least one of the first shunt (412,428) and second shunt (414,430) is open circuited.

7. The method of claim 6, wherein the resistor-capacitor circuit comprises:
a common point capacitor (1004); and
a common point resistor (1002) having a first terminal coupled to the bias voltage (VDD) and a second terminal coupled to the first load inductor (404,420) and second load inductor terminal (406,422), wherein the common point capacitor (1004) is coupled between the second terminal and a ground.

8. The method of claim 6, further comprising a first load resistor (408,424) coupled between the first load inductor (404,420) and the positive output and a second load resistor (410,426) coupled between the second load inductor (406,422) and the negative output.

## Patentansprüche

1. Elektronische Schaltungsanordnung, die Folgendes umfasst:
- wenigstens einen Differential-Paar-Verstärker (402, 416), der einen positiven Ausgang, der mit einem ersten Lastinduktor (404, 420) gekoppelt ist, und einen negativen Ausgang umfasst, der mit einem zweiten Lastinduktor (406, 522) gekoppelt ist;
- einen ersten Nebenschluss (412, 428), der eine erste chipexterne Impedanz aufweist, wobei der positive Ausgang mit einer Vorspannung (VDD) über den ersten Nebenschluss (412, 428) gekoppelt ist;
- einen zweiten Nebenschluss (414, 430), der eine zweite chipexterne Impedanz aufweist, wobei der negative Ausgang mit der Vorspannung (VDD) über den zweiten Nebenschluss (414, 430) gekoppelt ist, wobei der erste Nebenschluss (412, 428) ein erster Induktor oder eine erste Ferritperle ist und der zweite Nebenschluss (414, 430) ein zweiter Induktor oder eine zweite Ferritperle ist, und
- eine Widerstands-Kondensator-Schaltung, die Folgendes umfasst:
- einen Kondensator (1004) eines gemeinsamen Punktes, und
- einen Widerstand (1002) eines gemeinsamen Punktes, der einen ersten Anschluss, der mit der Vorspannung (VDD) gekoppelt ist, und einen zweiten Anschluss aufweist, der mit dem ersten Lastinduktor (404, 420) und dem zweiten Lastinduktor (406, 422) gekoppelt ist, und wobei der Kondensator (1004) des gemeinsamen Punktes zwischen den zweiten Anschluss und eine Masse geschaltet ist und die Widerstands-Kondensator-Schaltung so konfiguriert ist, dass sie einen maximalen Strom in den ersten und zweiten Lastinduktoren (404, 420; 406, 422) begrenzt, wenn wenigstens einer des ersten Nebenschlusses (412, 428) und des zweiten Nebenschlusses (414, 430) einen offenen Stromkreis bildet.

2. Elektronische Schaltungsanordnung nach Anspruch 1, wobei die Impedanz des ersten Nebenschlusses (412, 428) und die Impedanz des zweiten Nebenschlusses (414, 430) so ausgewählt werden, dass sie es erlauben, dass der wenigstens eine Differential-Paar-Verstärker (402, 416) ein positives verstärktes Signal (222(P)) an dem positiven Ausgang erzeugt, das größer als die Vorspannung (VDD) ist, und ein negatives verstärktes Signal (222(N)) an dem negativen Ausgang erzeugt, das größer als die Vorspannung (VDD) ist.

3. Elektronische Schaltungsanordnung nach Anspruch 1, wobei der wenigstens eine Differential-Paar-Verstärker (402, 416) und die Widerstands-Kondensator-Schaltung auf einem ersten Substrat integriert sind und der erste Nebenschluss (412, 428) und der zweite Nebenschluss (414, 430) auf einem zweiten Substrat integriert sind.

4. Elektronische Schaltungsanordnung nach Anspruch 1, wobei der wenigstens eine Differential-Paar-Verstärker (402, 416) so konfiguriert ist, dass er Signale verstärkt, die Frequenzen von 54-860 MHz aufweisen, um ein positives verstärktes Signal (222(P)) an dem positiven Ausgang und ein negatives verstärktes Signal (222(N)) an dem negativen Ausgang zu erzeugen.

5. Elektronische Schaltungsanordnung nach Anspruch 1, die des Weiteren Folgendes umfasst:
einen ersten Lastwiderstand (408, 424), der zwischen dem ersten Lastinduktor (404, 420) und dem positiven Ausgang gekoppelt ist; und
einen zweiten Lastwiderstand (410, 426), der zwischen dem zweiten Lastinduktor (406, 422) und dem negativen Ausgang gekoppelt ist.

6. Verfahren zur Erweiterung des dynamischen Bereichs eines Verstärkers (206), der bei einer Vorspannung (VDD) vorgespannt ist, wobei der Verstärker (206) einen ersten Lastinduktor (404, 420), der zwischen einem positiven Ausgang und der Vorspannung (VDD) gekoppelt ist, und einen zweiten Lastinduktor (406, 422) umfasst, der zwischen einem negativen Ausgang und der Vorspannung (VDD) gekoppelt ist, wobei das Verfahren Folgendes umfasst:
- differentielles Verstärken von Signalen, um ein Ausgangssignal zu erzeugen, das ein positives verstärktes Signal (222(P)) an dem positiven Ausgang und ein negatives verstärktes Signal (222(N)) an dem negativen Ausgang umfasst;
- Koppeln des positiven verstärkten Signals (222(P)) mit der Vorspannung (VDD) des Verstärkers (206) über einen ersten Nebenschluss (412, 428), der eine erste chipexterne Impedanz aufweist, und des negativen verstärkten Signals (222(N)) mit der Vorspannung (VDD) über einen zweiten Nebenschluss (414, 430), der eine zweite chipexterne Impedanz aufweist, um zu erlauben, dass das Ausgangssignal einen Spannungshub aufweist, der größer als die Vorspannung (VDD) ist; wobei der erste Nebenschluss (412, 428) ein erster Induktor oder eine erste Ferritperle ist und der zweite Nebenschluss (414, 430) ein zweiter Induktor oder eine zweite Ferritperle ist, und
- Koppeln der Vorspannung (VDD) mit dem ersten Lastinduktor (404, 420) und dem zweiten Lastinduktor (406, 422) über eine Widerstands-Kondensator-Schaltung zum Begrenzen eines maximalen Stroms in den ersten und zweiten Lastinduktoren, wenn wenigstens einer des ersten Nebenschlusses (412, 428) und des zweiten Nebenschlusses (414, 430) einen offenen Stromkreis bildet.

7. Verfahren nach Anspruch 6, wobei die Widerstands-Kondensator-Schaltung Folgendes umfasst:
einen Kondensator (1004) eines gemeinsamen Punktes, und
einen Widerstand (1002) eines gemeinsamen Punktes, der einen ersten Anschluss, der mit der Vorspannung (VDD) gekoppelt ist, und einen zweiten Anschluss aufweist, der mit dem ersten Lastinduktor (404, 420) und dem zweiten Lastinduktor (406, 422) gekoppelt ist, wobei der Kondensator (1004) des gemeinsamen Punktes zwischen dem zweiten Anschluss und einer Masse gekoppelt ist.

8. Verfahren nach Anspruch 6, das des Weiteren einen ersten Lastwiderstand (408, 424), der zwischen dem ersten Lastinduktor (404, 420) und dem positiven Ausgang gekoppelt ist, und einen zweiten Lastwiderstand (410, 426) umfasst, der zwischen dem zweiten Lastinduktor (406, 422) und dem negativen Ausgang gekoppelt ist.

## Revendications

1. Ensemble de circuits électroniques comprenant :
au moins un amplificateur à paire différentielle (402, 416) comportant une sortie positive couplée à une première inductance de charge (404, 420) et une sortie négative couplée à une seconde inductance de charge (406, 422) ;
un premier shunt (412, 428) ayant une première impédance hors puce, la sortie positive étant couplée à une tension de polarisation (VDD) par l'intermédiaire du premier shunt (412, 428) ;
un second shunt (414, 430) ayant une première impédance hors puce, la sortie négative étant couplée à la tension de polarisation (VDD) par l'intermédiaire du second shunt (414, 430), dans lequel le premier shunt (412, 428) est une première inductance ou une première perle de ferrite et le second shunt (414, 430) est une seconde inductance ou une seconde perle de ferrite et
un circuit résistance-condensateur comprenant :
un condensateur à point commun (1004) et
une résistance à point commun (1002) ayant une première borne couplée à la tension de polarisation (VDD) et une seconde borne couplée à la première inductance de charge (404, 420) et à la seconde inductance de charge (406, 422), et dans lequel le condensateur à point commun (1004) est couplé entre la seconde borne et une terre et le circuit résistance-condensateur est configuré pour limiter un courant maximal dans les première et seconde inductances de charge (404, 420 ; 406, 422) lorsqu'au moins un des premier shunt (412, 418) et second shunt (414, 430) est en circuit ouvert.

2. Ensemble de circuits électroniques selon la revendication 1, dans lequel l'impédance du premier shunt (412, 428) et l'impédance du second shunt (414, 430) sont choisies pour permettre à le au moins un amplificateur à paire différentielle (402, 416) de produire un signal amplifié positif (222(P)) au niveau de la sortie positive qui soit supérieur à la tension de polarisation (VDD) et un signal amplifié négatif 222(N) au niveau de la sortie négative qui soit supérieur à la tension de polarisation (VDD).

3. Ensemble circuit électronique selon la revendication 1, dans lequel le au moins un amplificateur à paire différentielle (402, 416) et le circuit résistance-condensateur sont intégrés sur un premier substrat et le premier shunt (412, 428) et le second shunt (414, 430) sont intégrés sur un second substrat.

4. Ensemble de circuitq électroniques selon la revendication 1, dans lequel le au moins un amplificateur à paire différentielle (402, 416) est configuré pour amplifier des signaux ayant des fréquences de 54 à 860 MHz pour produire un signal amplifié positif (222(P)) au niveau de la sortie positive et un signal amplifié négatif 222(N) au niveau de la sortie négative.

5. Ensemble de circuits électroniques selon la revendication 1, comprenant en outre :
une première résistance de charge (408, 424) couplée entre la première inductance de charge (404, 420) et la sortie positive ; et
une seconde résistance de charge (410, 426) couplée entre la seconde inductance de charge (406, 422) et la sortie négative.

6. Procédé d'extension de la plage dynamique d'un amplificateur (206) polarisé à une tension de polarisation (VDD), l'amplificateur (206) comprenant une première inductance de charge (404, 420) couplée entre une sortie positive et la tension de polarisation (VDD) et une seconde inductance de charge (406, 422) couplée entre une sortie négative et la tension de polarisation (VDD), comprenant les étapes suivantes:
amplification différentielle des signaux pour produire un signal de sortie comprenant un signal amplifié positif (222(P)) au niveau de la sortie positive et un signal amplifié négatif (222(N)) au niveau de la sortie négative ;
couplage du signal amplifié positif (222(P)) à la tension de polarisation (VDD) de l'amplificateur (206) par l'intermédiaire d'un premier shunt (412, 428) ayant une première impédance hors puce et du signal amplifié négatif (222(N)) à la tension de polarisation (VDD) par l'intermédiaire d'un second shunt (414, 430) ayant une seconde impédance hors puce pour permettre au signal de sortie d'avoir une excursion de tension supérieure à la tension de polarisation (VDD) ; dans lequel le premier shunt (412, 428) est une première inductance ou une première perle de ferrite et le second shunt (414, 430) est une seconde inductance ou une seconde perle de ferrite et
couplage de la tension de polarisation (VDD) à la première inductance de charge (404, 420) et à la seconde inductance de charge (406, 422) par l'intermédiaire d'un circuit résistance-condensateur pour limiter un courant maximal dans les première et seconde inductances de charge lorsqu'au moins des premier shunt (412, 428) et second shunt (414, 430) est en circuit ouvert.

7. Procédé selon la revendication 6, dans lequel le circuit résistance-condensateur comprend :
un condensateur à point commun (1004) ; et
une résistance à point commun (1002) ayant une première borne couplée à la tension de polarisation (VDD) et une seconde borne couplée à la première inductance de charge (404, 420) et à la seconde inductance de charge (406, 422), dans lequel le condensateur à point commun (1004) est couplé entre la seconde borne et une terre.

8. Procédé selon la revendication 6, comprenant en outre une première résistance de charge (408, 424) couplée entre la première inductance de charge (404, 420) et la sortie positive et une seconde résistance de charge (410, 426) couplée entre la seconde inductance de charge (406, 422) et la sortie négative.
